# EUROPÄISCHE PATENTANMELDUNG

(11) **EP 3 562 285 A1**
(43) Veröffentlichungstag der Anmeldung: **30.10.2019**
(21) Anmeldenummer: 18169242.7
(22) Anmeldetag: 25.04.2018
(51) Int. Cl.: H05K 7/14

(54) **VERBINDEN ELEKTRISCHER BAUELEMENTE**

(71) Anmelder: Siemens Aktiengesellschaft, 80333 München (DE)
(72) Erfinder: PÖHLER, Dirk, 08056 Zwickau (DE); SEIDL, Joachim, 92237 Sulzbach-Rosenberg (DE); STEINDL, Dieter, 92284 Poppenricht (DE); WILKE, Klaus, 12527 Berlin (DE)

(57) **Zusammenfassung**

Die Erfindung betrifft eine Backplane (1) zum elektrischen Verbinden elektrischer Bauelemente (3) und ein Verfahren zur Herstellung einer Backplane (1). Die Backplane (1) umfasst eine Trägerplatte (5), auf der Trägerplatte (5) angeordnete Leiterbahnen (7) und wenigstens eine in die Trägerplatte (5) integrierte Sensoreinheit (9). Die wenigstens eine Sensoreinheit (9) wird durch ein additives Fertigungsverfahren in die Trägerplatte (5) integriert.

## Beschreibung

Die Erfindung betrifft eine Backplane zum elektrischen Verbinden elektrischer Bauelemente und ein Verfahren zur Herstellung einer derartigen Backplane. Ferner betrifft die Erfindung einen Schaltschrank.

Unter einer Backplane wird hier ein Träger für elektrische Bauelemente verstanden, der Leiterbahnen zum elektrischen Verbinden der elektrischen Bauelemente aufweist. Derartige elektrische Bauelemente sind beispielsweise Schütze, Schalter, Steuerungseinheiten oder Eingabe-/Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

Der Erfindung liegt die Aufgabe zugrunde, eine hinsichtlich ihrer Funktionalität verbesserte Backplane, ein Verfahren zur Herstellung einer derartigen Backplane und einen verbesserten Schaltschrank anzugeben.

Die Aufgabe wird erfindungsgemäß durch eine Backplane mit den Merkmalen des Anspruchs 1, einen Schaltschrank mit den Merkmalen des Anspruchs 11 und ein Verfahren mit den Merkmalen des Anspruchs 12 gelöst.

Vorteilhafte Ausgestaltungen der Erfindung sind Gegenstand der Unteransprüche.

Eine erfindungsgemäße Backplane zum elektrischen Verbinden elektrischer Bauelemente umfasst eine Trägerplatte, auf der Trägerplatte angeordnete Leiterbahnen und wenigstens eine in die Trägerplatte integrierte Sensoreinheit.

Eine erfindungsgemäße Backplane weist somit neben Leiterbahnen auch wenigstens eine in die Backplane integrierte Sensoreinheit auf. Die Integration einer Sensoreinheit in die Backplane erhöht vorteilhaft die Funktionalität der Backplane. Durch geeignete Sensoreinheiten können beispielsweise die Funktion von Leiterbahnen, insbesondere bereits während der Inbetriebnahme der Backplane, und/oder Betriebsbedingungen der Backplane erfasst und überwacht werden. Dadurch können vorteilhaft die Betriebssicherheit und die elektrische Zuverlässigkeit der Backplane erhöht werden, beispielsweise indem die Instandhaltung der Backplane unter Berücksichtigung der erfassten Sensorsignale durchgeführt wird. Die von einer Sensoreinheit erfassten Sensorsignale können beispielsweise einer übergeordneten Applikation verfügbar gemacht werden. Insbesondere können die Sensorsignale in eine Datenwolke übertragen und in dieser ausgewertet und/oder verwendet werden.

Ausgestaltungen der Erfindung sehen vor, dass wenigstens eine Sensoreinheit einen Stromsensor zum Erfassen eines elektrischen Stroms aufweist, und/oder dass wenigstens eine Sensoreinheit einen Spannungssensor zum Erfassen einer elektrischen Spannung aufweist, und/oder dass wenigstens eine Sensoreinheit einen Leistungssensor zum Erfassen einer elektrischen Leistung aufweist.

Die vorgenannten Ausgestaltungen der Erfindung ermöglichen insbesondere, die Funktion von Leiterbahnen durch die Erfassung von durch die Leiterbahnen fließenden elektrischen Strömen, an den Leiterbahnen anliegenden elektrischen Spannungen und/oder über die Leiterbahnen übertragenen elektrischen Leistungen zu überwachen und insbesondere Fehlfunktionen und Ausfälle von Leiterbahnen zu erkennen. Ferner ermöglichen sie beispielsweise, elektrische Überspannungen und Überströme zu erkennen, um elektrische Bauelemente erforderlichenfalls abzuschalten und eine Schädigung oder Zerstörung der elektrischen Bauelemente zu verhindern.

Weitere Ausgestaltungen der Erfindung sehen vor, dass wenigstens eine Sensoreinheit einen Temperatursensor zum Erfassen einer Temperatur aufweist, und/oder dass wenigstens eine Sensoreinheit einen Dehnungssensor zum Erfassen einer Verformung der Trägerplatte aufweist, und/oder dass wenigstens eine Sensoreinheit einen Vibrationssensor zum Erfassen einer Vibration der Trägerplatte aufweist, und/oder dass wenigstens eine Sensoreinheit einen Beschleunigungssensor zum Erfassen einer Beschleunigung der Trägerplatte aufweist, und/oder dass wenigstens eine Sensoreinheit einen Lichtsensor aufweist, und/oder dass wenigstens eine Sensoreinheit ein Magnetometer aufweist, und/oder dass wenigstens eine Sensoreinheit einen Gassensor aufweist, und/oder dass wenigstens eine Sensoreinheit einen Näherungsschalter aufweist.

Die vorgenannten Ausgestaltungen der Erfindung ermöglichen, Betriebsbedingungen der Backplane zu erfassen und zu überwachen. Durch die Erfassung und Überwachung einer Temperatur kann beispielsweise eine drohende oder erfolgte Überhitzung der Backplane und/oder mit ihr verbundener elektrischer Bauelemente erkannt werden, um rechtzeitig Gegenmaßnahmen zu ergreifen, die eine Schädigung oder Zerstörung der Backplane und/oder der elektrischen Bauelemente durch eine Überhitzung verhindern, oder durch eine Überhitzung verursachte Schäden zu erkennen und zu beheben. Durch die Erfassung und Überwachung einer Dehnung, Beschleunigung und/oder einer Vibration der Trägerplatte kann beispielsweise eine drohende oder erfolgte mechanische Überbelastung der Backplane durch eine mechanische Spannung, einen Stoß und/oder eine Vibration erkannt werden, um rechtzeitig Gegenmaßnahmen zu ergreifen, die eine Schädigung oder Zerstörung der Backplane durch eine mechanische Überbelastung verhindern, oder durch eine mechanische Überbelastung verursachte Schäden zu erkennen und zu beheben. Durch die Erfassung und Überwachung eines Lichteinfalls oder eines Gases in der Umgebung der Backplane kann beispielsweise eine Rauchentwicklung (beispielsweise durch einen als Rauchmelder ausgebildeten Sensor) und damit eine Brandgefahr in der Umgebung der Backplane erkannt werden. Im Falle einer in einem Schaltschrank angeordneten Backplane kann ferner durch Erfassung und Überwachung eines Lichteinfalls beispielsweise erkannt werden, ob der Schaltschrank geöffnet wird. Durch einen Näherungsschalter kann beispielsweise erkannt werden, ob sich eine Person der Backplane nähert, beispielsweise um die Person vor einer Hochspannung zu warnen.

Ein erfindungsgemäßer Schaltschrank weist eine erfindungsgemäße Backplane auf.

Die Verwendung einer erfindungsgemäßen Backplane in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel. Die Integration von wenigstens einer Sensoreinheit in die Backplane hat darüber hinaus die oben bereits genannten Vorteile, die Funktion der Leiterbahnen und die Betriebsbedingungen der Backplane erfassen und überwachen zu können, insbesondere um die Betriebssicherheit und Instandhaltung der Backplane zu verbessern.

Bei dem erfindungsgemäßen Verfahren zur Herstellung einer erfindungsgemäßen Backplane wird die wenigstens eine Sensoreinheit durch ein additives Fertigungsverfahren in die Trägerplatte integriert. Beispielsweise wird die wenigstens eine Sensoreinheit in die Trägerplatte integriert, indem die Trägerplatte wenigstens in einem die Sensoreinheit umgebenden Bereich mit einem 3D-Druck hergestellt wird, der die Sensoreinheit in die Trägerplatte einbettet. Unter einem 3D-Druck wird ein Verfahren verstanden, bei dem ein dreidimensionales Objekt durch computergesteuertes schichtweises Auftragen von Material hergestellt wird.

Die Integration einer Sensoreinheit durch ein additives Fertigungsverfahren in die Trägerplatte, insbesondere durch eine Einbettung der Sensoreinheit in die Trägerplatte mittels eines 3D-Drucks, ermöglicht eine effiziente Bestückung der Backplane mit der Sensoreinheit. Insbesondere entfallen eine aufwändige nachträgliche Befestigung der Sensoreinheit auf der Trägerplatte und dafür erforderliche Befestigungsstrukturen.

Eine weitere Ausgestaltung der Erfindung sieht vor, dass die Leiterbahnen mit einem 3D-Druck auf die Trägerplatte aufgebracht werden. Beispielsweise werden die Leiterbahnen aus einer elektrisch leitfähigen Paste, insbesondere aus einer Kupferpaste, Aluminiumpaste, Messingpaste oder Silberpaste, gedruckt.

Die vorgenannte Ausgestaltung der Erfindung berücksichtigt, dass unterschiedliche Konfigurationen elektrisch zu verbindender Bauelemente auch unterschiedliche Querschnitte und Verläufe der Leiterbahnen erfordern. Beispielsweise sind für leistungsführende Leitungen dickere Leiterbahnen als für Signalleitungen erforderlich, und unterschiedliche Anordnungen der Bauelemente erfordern unterschiedliche Verläufe der Leiterbahnen. Die Fertigung der Leiterbahnen mit einem 3D-Druck ermöglicht, die Querschnitte und die Verläufe der Leiterbahnen in einfacher Weise flexibel der Konfiguration der jeweils elektrisch zu verbindenden Bauelemente anzupassen. Insbesondere ermöglicht dies eine kostengünstige Serienfertigung von Backplanes für unterschiedliche Konfigurationen elektrischer Bauelemente. Ein 3D-Druck der Leiterbahnen aus einer elektrisch leitfähigen, aushärtbaren Paste ist vorteilhaft, da sich eine Paste in einfacher Weise aufbringen lässt und nach dem Aufbringen nicht verläuft und durch Aushärten stabilisiert werden kann. Kupferpasten, Aluminiumpasten, Messingpasten und Silberpasten eignen sich aufgrund ihrer guten elektrischen Leitfähigkeit besonders gut als Material für den 3D-Druck der Leiterbahnen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: schematisch eine Backplane,
- FIG 2: eine perspektivische Darstellung eines Schalt-schranks.

Einander entsprechende Teile sind in den Figuren mit denselben Bezugszeichen versehen.

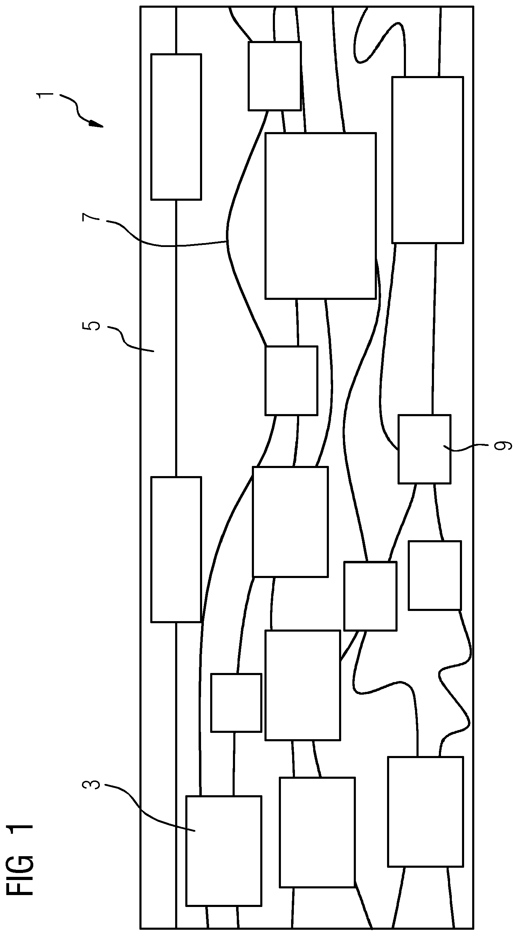

Figur 1 zeigt eine schematische Darstellung einer Backplane 1 in einer Draufsicht auf die Backplane 1. Auf der Backplane 1 sind mehrere elektrische Bauelemente 3 angeordnet.

Ein elektrisches Bauelement 3 kann beispielsweise ein Schütz, ein Schalter, eine Steuereinheit, eine Eingabe- /Ausgabeeinheit, ein Sanftstarter oder ein Frequenzumrichter sein.

Die Backplane 1 weist eine Trägerplatte 5, auf der Trägerplatte 5 angeordnete Leiterbahnen 7 und in die Trägerplatte 5 integrierte Sensoreinheiten 9 auf.

Die Leiterbahnen 7 verbinden jeweils elektrische Bauelemente 3 und/oder Sensoreinheiten 9 elektrisch miteinander.

Eine Sensoreinheit 9 kann beispielsweise einen Stromsensor zum Erfassen eines elektrischen Stroms, einen Spannungssensor zum Erfassen einer elektrischen Spannung, einen Temperatursensor zum Erfassen einer Temperatur, einen Leistungssensor zum Erfassen einer elektrischen Leistung,einen Dehnungssensor zum Erfassen einer Verformung der Trägerplatte 5, einen Vibrationssensor zum Erfassen einer Vibration der Trägerplatte 5, einen Beschleunigungssensor zum Erfassen einer Beschleunigung der Trägerplatte 5, einen Lichtsensor, ein Magnetometer, einen Gassensor, einen Näherungsschalter oder eine Auswerteeinheit zum Auswerten von Sensorsignalen aufweisen.

Bei der Herstellung der Backplane 1 werden die Sensoreinheiten 9 durch ein additives Fertigungsverfahren in die Trägerplatte 5 integriert. Beispielsweise wird die Trägerplatte 5 wenigstens in jedem eine Sensoreinheit 9 umgebenden Bereich mit einem 3D-Druck hergestellt, der die jeweilige Sensoreinheit 9 in die Trägerplatte 5 einbettet.

Ferner werden bei der Herstellung der Backplane 1 die Leiterbahnen 7 beispielsweise mit einem 3D-Druck auf die Trägerplatte 5 aufgebracht. Beispielsweise werden die Leiterbahnen 7 aus einer elektrisch leitfähigen Paste, insbesondere aus einer Kupferpaste, Aluminiumpaste, Messingpaste oder Silberpaste, gedruckt, die nach dem Auftragen auf die Trägerplatte 5 gehärtet wird.

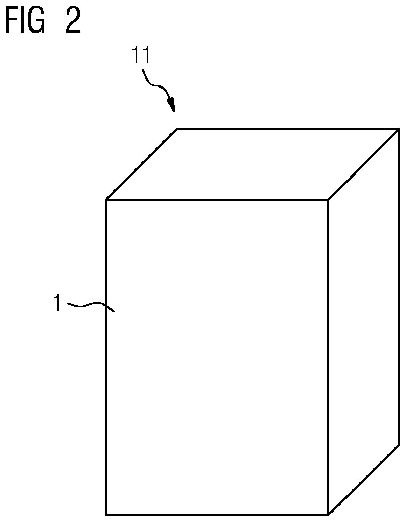

Figur 2 zeigt eine perspektivische Darstellung eines Schaltschranks 11. Der Schaltschrank 11 weist eine anhand der Figur 1 beschriebene Backplane 1 auf, die eine Rückwand des Schaltschranks 11 bildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Backplane (1) zum elektrischen Verbinden elektrischer Bauelemente (3), die Backplane (1) umfassend
- eine Trägerplatte (5),
- auf der Trägerplatte (5) angeordnete Leiterbahnen (7) und
- wenigstens eine in die Trägerplatte (5) integrierte Sensoreinheit (9) .

2. Backplane (1) nach Anspruch 1,
**dadurch gekennzeichnet, dass** wenigstens eine Sensoreinheit (9) einen Stromsensor zum Erfassen eines elektrischen Stroms aufweist.

3. Backplane (1) nach einem der vorhergehenden Ansprüche,
**dadurch gekennzeichnet, dass** wenigstens eine Sensoreinheit (9) einen Spannungssensor zum Erfassen einer elektrischen Spannung aufweist.

4. Backplane (1) nach einem der vorhergehenden Ansprüche,
**dadurch gekennzeichnet, dass** wenigstens eine Sensoreinheit (9) einen Temperatursensor zum Erfassen einer Temperatur aufweist.

5. Backplane (1) nach einem der vorhergehenden Ansprüche,
**dadurch gekennzeichnet, dass** wenigstens eine Sensoreinheit (9) einen Dehnungssensor zum Erfassen einer Verformung der Trägerplatte (5) aufweist.

6. Backplane (1) nach einem der vorhergehenden Ansprüche,
**dadurch gekennzeichnet, dass** wenigstens eine Sensoreinheit (9) einen Beschleunigungssensor zum Erfassen einer Beschleunigung der Trägerplatte (5) aufweist.

7. Backplane (1) nach einem der vorhergehenden Ansprüche,
**dadurch gekennzeichnet, dass** wenigstens eine Sensoreinheit (9) einen Lichtsensor aufweist.

8. Backplane (1) nach einem der vorhergehenden Ansprüche,
**dadurch gekennzeichnet, dass** wenigstens eine Sensoreinheit ein Magnetometer aufweist.

9. Backplane (1) nach einem der vorhergehenden Ansprüche,
**dadurch gekennzeichnet, dass** wenigstens eine Sensoreinheit (9) einen Gassensor aufweist.

10. Backplane (1) nach einem der vorhergehenden Ansprüche,
**dadurch gekennzeichnet, dass** wenigstens eine Sensoreinheit (9) einen Näherungsschalter aufweist.

11. Schaltschrank (11) mit einer gemäß einem der vorhergehenden Ansprüche ausgebildeten Backplane (1).

12. Verfahren zur Herstellung einer gemäß einem der Ansprüche 1 bis 10 ausgebildeten Backplane (1), wobei die wenigstens eine Sensoreinheit (9) durch ein additives Fertigungsverfahren in die Trägerplatte (5) integriert wird.

13. Verfahren nach Anspruch 12,
**dadurch gekennzeichnet, dass** die wenigstens eine Sensoreinheit (9) in die Trägerplatte (5) integriert wird, indem die Trägerplatte (5) wenigstens in einem die Sensoreinheit (9) umgebenden Bereich mit einem 3D-Druck hergestellt wird, der die Sensoreinheit (9) in die Trägerplatte (5) einbettet.

14. Verfahren nach Anspruch 12 oder 13,
**dadurch gekennzeichnet, dass** die Leiterbahnen (7) mit einem 3D-Druck aus einer elektrisch leitfähigen Paste gedruckt werden, die nach dem Auftragen auf die Trägerplatte (5) gehärtet wird.

15. Verfahren nach Anspruch 14,
**dadurch gekennzeichnet, dass** die elektrisch leitfähige Paste eine Kupferpaste oder Aluminiumpaste oder Messingpaste oder Silberpaste ist.
